# EUROPEAN PATENT APPLICATION

(11) **EP 4 776 785 A1**
(43) Date of publication of application: **15.07.2026**
(21) Application number: 25188306.2
(22) Date of filing: 09.07.2025
(51) Int. Cl.: H10D 10/01, H10D 10/40, H10D 62/10, H10D 62/17, H10D 64/23, H10D 10/80

(54) **VERTICAL BIPOLAR TRANSISTOR WITH EMITTER CONTACT WIDER THAN EMITTER TERMINAL AND RELATED METHOD**

(30) Priority: 09.01.2025 US 202519014335
(71) Applicant: GlobalFoundries U.S. Inc., Malta, NY 12020 (US)
(72) Inventor: DeAngelis, Jacob M., Essex Junction 05452 (US); Shank, Steven M., Essex Junction 05452 (US); McTaggart, Sarah A., Essex Junction 05452 (US); Lydon-Nuhfer, Megan Elizabeth, Essex Junction 05452 (US); Raghunathan, Uppili S., Essex Junction 05452 (US); Dillon, Daisy A., Essex Junction 05452 (US)
(74) Representative: Grünecker Patent- und Rechtsanwälte PartG mbB

(57) **Abstract**

The disclosure provides a vertical bipolar transistor with an emitter contact (146) wider than an emitter terminal (114, 148), and related methods. A structure of the disclosure includes an emitter contact (146) within an inter-level dielectric (140) layer and on an emitter terminal (114, 148) of a bipolar transistor (100), wherein a horizontal width of the emitter contact (146) is greater than a horizontal width of the emitter terminal (114, 148) thereunder.

## Description

### BACKGROUND

The present disclosure relates to bipolar transistor structures and methods to form such structures.

Internet-of-Things (IOT) devices, wearable devices, smartphone processors, automotive electronics, and radio frequency integrated circuits (RFICs) (including millimeter wave (mmWave) ICs) can benefit from the inclusion of bipolar junction transistors (BJTs) because BJTs tend to have more drive and are generally considered better suited for analog functions than field effect transistors (FETs). BJTs are typically formed as vertical devices (e.g., with an in-substrate collector, a base including an intrinsic base region aligned above the collector region and extrinsic base regions on opposing sides of the intrinsic base region, and an emitter aligned above the intrinsic base region). In such vertical BJT structures, device size scaling and, particular, emitter region size scaling is limited by emitter contact overlay tolerance limits.

### SUMMARY

The illustrative aspects of the present disclosure are designed to solve the problems herein described and/or other problems not discussed.

Embodiments of the disclosure provide a structure including: an emitter contact within an inter-level dielectric (ILD) layer and on an emitter terminal of a bipolar transistor, wherein a horizontal width of the emitter contact is greater than a horizontal width of the emitter terminal thereunder.

Other embodiments of the disclosure provide a structure including: a collector terminal including an epitaxial semiconductor material on a subcollector; an isolation layer on the subcollector and adjacent the collector terminal; a base terminal including: an intrinsic base on the collector terminal, wherein a semiconductor film is on the intrinsic base; and an extrinsic base adjacent the semiconductor film and on an upper surface of the isolation layer and in contact with the intrinsic base; an emitter terminal on the semiconductor film; and an emitter contact within an inter-level dielectric (ILD) layer and on the emitter terminal, wherein a horizontal width of the emitter contact is greater than a horizontal width of the emitter terminal thereunder.

Additional embodiments of the disclosure provide a method including: forming an emitter contact within an inter-level dielectric (ILD) layer and on an emitter terminal of a bipolar transistor, wherein a horizontal width of the emitter contact is greater than a horizontal width of the emitter terminal thereunder.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 depicts a cross-sectional view a structure according to embodiments of the disclosure.
FIG. 2 depicts an expanded cross-sectional view a structure according to embodiments of the disclosure.
FIG. 3 depicts a cross-sectional view of a structure according to further embodiments of the disclosure.
FIG. 4 depicts a cross-sectional view of a structure according to additional embodiments of the disclosure.
FIG. 5 depicts an expanded cross-sectional view of a structure according to still further embodiments of the disclosure.
FIGS. 6-10 depict cross-sectional views of processes in methods to form a structure according to embodiments of the disclosure.
FIG. 11 depicts a cross-sectional view of a process in methods to form a structure according to other embodiments of the disclosure.
FIG. 12 depicts a cross-sectional view of a process in methods to form a structure according to additional embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

The disclosure provides a structure with an emitter contact wider than an emitter terminal, and related methods. A structure of the disclosure includes an emitter contact within an inter-level dielectric (ILD) layer and on an emitter terminal of a bipolar transistor, wherein a horizontal width of the emitter contact is greater than a horizontal width of the emitter terminal thereunder.

Bipolar junction transistor (BJT) structures, such as those in embodiments of the disclosure, operate using multiple "P-N junctions." The term "P-N" refers to two adjacent materials having different types of conductivity (i.e., P-type and N-type), which may be induced through dopants within the adjacent material(s). A P-N junction, when formed in a device, may operate as a diode. A diode is a two-terminal element, which behaves differently from conductive or insulative materials between two points of electrical contact. Specifically, a diode provides high conductivity from one contact to the other in one voltage bias direction (i.e., the "forward" direction), but provides little to no conductivity in the opposite direction (i.e., the "reverse" direction). In the case of the P-N junction, the orientation of a diode's forward and reverse directions may be contingent on the type and magnitude of bias applied to the material composition of one or both terminals, which affects the size of the potential barrier. In the case of a junction between two semiconductor materials, the potential barrier will be formed along the interface between the two semiconductor materials. Generally, a BJT structure includes a base region vertically or horizontally between emitter and collector materials. A BJT can be either a PNP-type BJT or an NPN-type BJT. In a PNP-type BJT, the emitter and collector regions have P-type conductivity and at least a portion of the base region has N-type conductivity. In an NPN-type BJT, the emitter and collector regions have N-type conductivity and at least a portion of the base has P-type conductivity. Additionally, it should be noted that, in a conventional BJT, the same semiconductor material (e.g., silicon) can be used for the base, collector and emitter. Alternatively, a BJT can be a heterojunction bipolar transistor (HBT). In a HBT, the collector and emitter are made, at least in part, of one semiconductor material (e.g., silicon) and the base is made, at least in part, of a different semiconductor material (e.g., silicon germanium). The use of differing semiconductor materials at the emitter-base junction and at the base-collector junction creates heterojunctions suitable for handling higher frequencies.

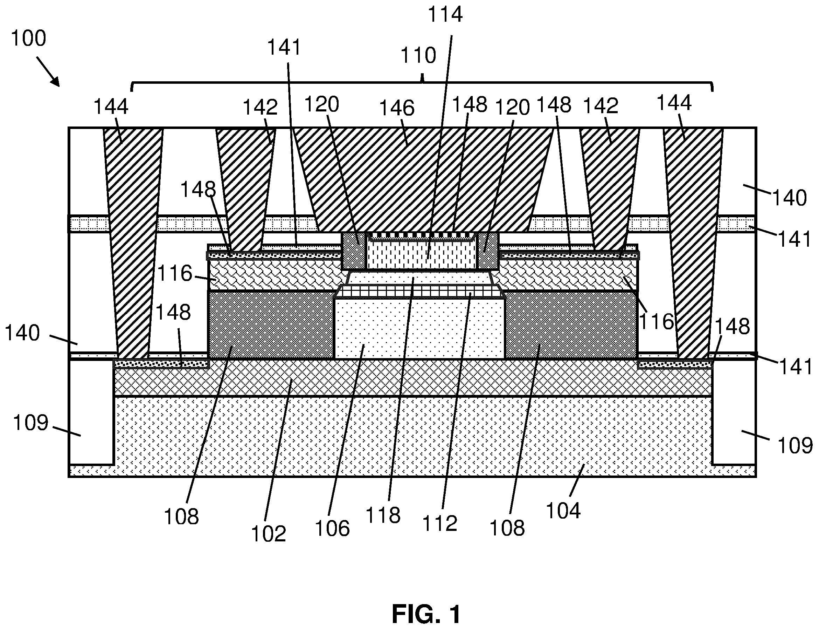

Referring to FIG. 1, a structure 100 according to the disclosure may include: a bipolar transistor (also abbreviated as a "BJT" to indicate "bipolar junction transistor,") 110. Bipolar transistor 110 can, optionally, be a heterojunction bipolar transistor (HBT). In any case BJT can be, e.g., a vertically oriented bipolar transistor as discussed herein, in which an emitter contact 146 has a larger horizontal width than an emitter terminal 114 of bipolar transistor 110. In various implementations, emitter contact 146 may be at least partially on dielectric materials (e.g., spacer(s) 120 and/or inter-level dielectric (ILD) layers 140) and may vertically overlie an extrinsic base 116 and/or silicide layers 148 on extrinsic base(s) 116. Structure 100 may be formed on a subcollector 102 (i.e., a doped portion of a semiconductor substrate) including, e.g., one or more monocrystalline semiconductor materials. Subcollector 102 may include but is not limited to silicon, germanium, silicon germanium (SiGe), silicon carbide, or any other common IC semiconductor substrates. In the case of SiGe, the germanium concentration in subcollector 102 may differ from other SiGe-based structures described herein. A portion or entirety of subcollector 102 may be strained. Subcollector 102 may be doped (i.e., it may define a "doped well" ), e.g., to enable coupling to the lower active semiconductor materials of a vertical bipolar transistor. Subcollector 102 may have any conceivable doping type and/or doping composition appropriate for use within and/or coupling to the collector terminal of a bipolar transistor. For instance, subcollector 102 may have the same dopant type as a collector 106 formed thereon, e.g., P-type doping in the case of a PNP-type BJT or N-type doping in the case of an NPN-type BJT, and/or may have a higher or lower dopant concentration therein.

Collector 106 may be on subcollector 102, e.g., as a single layer or multiple similarly doped but distinct layers formed by epitaxial deposition of silicon, SiGe, and/or other semiconductor materials on subcollector 102 and may have a predetermined doping type, e.g., by being doped in-situ or during formation of semiconductor material(s) of subcollector 102 and/or subcollector 102. Collector 106 is monocrystalline in structure. Collector 106 may define active semiconductor material of a vertical bipolar transistor, and thus may be vertically below other terminals (i.e., base, including extrinsic and intrinsic base regions, and emitter terminals discussed herein) of bipolar transistor 110. Collector 106 is illustrated as having vertical sidewalls over subcollector 102. However, collector 106 may have other shapes (e.g., sloped sidewalls, curved sidewalls, etc.) as a result of varying manufacturing techniques.

Structure 100 includes a set of isolation layers 108 on 102 for additional electrical and physical separation of bipolar transistor 110 from other components. Each isolation layer 108 may be horizontally adjacent a respective side of collector 106. Isolation layer 108 may extend above subcollector 102 to approximately the same height as collector 106, and optionally, alongside portions of an intrinsic base 112 thereon. Isolation layers 108 thereby allow extrinsic base(s) 116 to be formed on portions isolation layer 108 and adjacent materials (e.g., intrinsic base 112 and semiconductor film 118 thereof) simultaneously as discussed elsewhere herein. Isolation layer 108 may include, e.g., an oxide-based insulator (e.g., silicon dioxide (SiO₂)), or other materials having similar properties. Isolation layer 108 may have the same composition as insulator 109 discussed herein, but this is not necessarily required and thus isolation layers 108 are shown with different cross-hatching from insulator 109 where applicable. Isolation layers 108 may be formed, e.g., by deposition of desired material(s) on subcollector 102, insulator 109, etc. In a further example, isolation layer(s) 108 each may include multiple layers having different materials, and particularly may include an oxide-nitride-oxide (ONO) configuration over subcollector 102.

Insulator 109, which optionally may be subdivided into multiple layers and/or materials of varying width and/or depth, may also be on subcollector 102 to horizontally separate various active semiconductor materials on substrate 104. As shown, some insulators 109 may extend vertically into substrate 104, whereas others may be located on subcollector 102 to prevent electrical shorting between subcollector 102 and overlying areas of bipolar transistor 110. As discussed elsewhere herein insulator 109 initially may extend over substrate 104 as a single layer. Portions of insulator 109 may be removed to form a trench, which may undercut certain remaining portions of insulator 109 near subcollector 102. The undercut portions of insulator 109 may form substantially triangular divots, recesses, etc., where collector 106 material may be grown. Thus, collector 106 when formed may have a tapered or sloped shape, as shown. In cases where collector 106 has tapered sidewalls, various materials on collector 106 (e.g., intrinsic base 112 discussed herein) also may have tapered sidewall profiles, e.g., by selective epitaxial growth of additional material on collector 106.

Bipolar transistor 110 may include a base terminal including, collectively, an intrinsic base 112 on collector 106 and an extrinsic base 116 coupled to intrinsic base 112. Intrinsic base 112 and extrinsic base 116 may have different properties but function in bipolar transistor 110 as a single terminal. As illustrated, intrinsic base 112 may have inwardly tapered sidewalls such that the top surface of intrinsic base 112 is narrower in width than the top surface of collector 106. Intrinsic base 112 may include, e.g., monocrystalline SiGe or any other monocrystalline semiconductor material that is doped to have a predetermined polarity. Intrinsic base 112 may include a different semiconductor material (e.g., silicon germanium as opposed to silicon) than collector and 106 and an emitter 114 thereover. The use of differing semiconductor materials at the emitter-base junction and at the base-collector junction creates heterojunctions, which are, for example, suitable for handling higher frequencies. In this case, the BJT is referred to in the art as an HBT as noted herein. In the case where the bipolar transistor is an NPN-type transistor and subcollector 102, collector 106, and emitter 114 are doped n-type, intrinsic base 112 may be doped p-type to form a P-N junction, and hence a base-to-collector interface. It is also understood that intrinsic base 112 may be doped n-type in the case where the bipolar transistor is a PNP-type transistor. However embodied, intrinsic base 112 may extend to a predetermined height over collector 106. Intrinsic base 112 is illustrated with vertically extending sidewalls but may have sidewalls with a similar or different profile to collector 106 thereunder.

Intrinsic base 112 may be structurally and compositionally distinct from other portions of a base terminal for bipolar transistor 110. Intrinsic base 112 in particular may be lightly doped, or possibly undoped, whereas an extrinsic base 116 elsewhere in bipolar transistor 110 may be doped more highly than intrinsic base 112. Intrinsic base 112 may be formed, e.g., by forming a layer of semiconductor material, which may be monocrystalline silicon or SiGe as discussed herein, on collector 106. Additional semiconductor material may be formed to create intrinsic base 112 through selective epitaxial growth and/or similar processes to form additional semiconductor material while preserving the crystallographic orientation and/or composition of the underlying material(s). Selective epitaxial growth of intrinsic base 112 in particular may maintain the shape and orientation of the sidewalls of collector 106.

Intrinsic base 112 also may include a semiconductor film 118 on its upper surface to enable deposition and growth of other semiconductor material(s) of different conductivity types elsewhere in the forming of structure 100. Semiconductor film 118 may include, e.g., non-doped silicon (Si) in various crystalline forms, e.g., single crystallographic orientation Si, polycrystalline Si, etc. As discussed herein, semiconductor film 118 may be considered to be a part of intrinsic base 112 and may be formed by forming intrinsic base 112 material to a desired height before forming semiconductor film 118 thereon, and/or by removing a portion of intrinsic base 112 material for replacement with semiconductor film 118. Semiconductor film 118 also may be formed by any other currently known or later developed technique to form transitional semiconductor material suitable for subsequent forming of extrinsic base 116 and/or emitter 114 material thereon, having varying conductivity types and/or dopant concentrations. Semiconductor film 118 may function, electrically, as a part of intrinsic base 112 but may have a different composition to function as an etch stop layer to control the location and size of emitter 114. Thus, singular references to intrinsic base 112 herein may refer to intrinsic base 112 and semiconductor film 118, collectively.

The base terminal of bipolar transistor 110 may also include extrinsic base(s) 116 on outer portion(s) of intrinsic base 112. Extrinsic base(s) 116 may include a polycrystalline semiconductor (e.g., polycrystalline SiGe) with a relatively high amount of the same doping type as (e.g., more p-type doping than) intrinsic base 112. Extrinsic base(s) 116 may be formed, e.g., by depositing an initial (seed) layer of monocrystalline and/or other semiconductor materials on intrinsic base 112. Through selective epitaxial growth, deposition, and/or other processing, extrinsic base(s) 116 can be formed from the initial layer to a desired height. Extrinsic base 116, by being formed through selective epitaxial growth may have sidewalls that are similarly shaped and/or substantially aligned with the sidewalls of intrinsic base 112 (and perhaps collector 106) thereunder.

Emitter 114 may be on the center portion of intrinsic base 112. In an example, emitter 114 may be horizontally between portions of extrinsic bases 116 that extend vertically above semiconductor film 118. A set of spacers 120 located adjacent emitter 114 may electrically isolate emitter 114 from extrinsic bases 116. Emitter 114 may be formed on and above intrinsic base 112, e.g., by forming a stack of materials including portions of extrinsic base(s) 116, removing a portion of the stack of materials, and forming emitter 114 and/or other components within and/or in place of the removed extrinsic base 116 material. Emitter 114 may have the same doping type as subcollector 102 and collector 106, and thus, has an opposite doping type relative to extrinsic base 116 (and intrinsic base 112, if doped). In the case where bipolar transistor 110 is an NPN device, collector 106 and emitter 114 may be doped n-type to provide the two n-type active semiconductor materials and intrinsic base 112 may be doped p-type. Emitter 114 may include polycrystalline silicon and/or other monocrystalline semiconductor materials, including one or more materials used elsewhere in structure 100 to form subcollector 102, collector 106, extrinsic base 116 (with different doping), etc.

One or more spacers 120 may be adjacent emitter 114 and over adjacent portions of extrinsic base(s) 116. Although one spacer 120 is shown adjacent each sidewall of emitter 114, such spacers 120 may include multiple layers of material in a variety of arrangements. Other compositions and/or arrangements of spacers 120 currently known or later developed also may be used. Spacer(s) 120 thus may include oxide materials, nitride materials, and/or any other insulative material discussed herein, e.g., compositions similar to insulator 109 or other insulating structures. Spacer(s) 120 may be formed, e.g., by depositing layers of spacer material as part of a stack, removing portions of the stack where emitter 114 is desired, and optionally forming additional portions of spacer 120 material to cover any exposed surfaces and inner sidewalls of extrinsic base 116 before other materials (e.g., emitter 114) are formed adjacent spacers 120 and on a desired portion of semiconductor film 118. In some implementations, spacer(s) 120 may include a single layer or more than two layers. Spacers 120 also may extend vertically alongside emitter 114 such that they are horizontally between emitter 114 and extrinsic base(s) 116. Spacers 120 may have different compositions to control (e.g., increase) the electrical insulation between emitter 114 and extrinsic base 116.

Structure 100 may include an inter-level dielectric (ILD) layer 140 over insulator 109, extrinsic bases 116, emitter 114, spacers 120, etc. ILD layer 140 may include the same insulating material as insulator 109 or may include a different electrically insulative material for vertically separating active materials from overlying materials, e.g., various horizontally extending wires or vias. ILD layer 140 and insulator 109 nonetheless constitute different components, e.g., due to insulator 109 being vertically between subcollector 102 and the various active components of structure 100. ILD layer 140 may be formed by deposition and/or other techniques to provide electrically insulating materials, and can then be planarized (e.g., using CMP), such that its upper surface remains above any active components formed on subcollector 102. One or more barrier layers 141 including, e.g., nitride-based dielectric materials (such as silicon nitride (SiN)) may vertically separate different ILD layers 140, and as discussed elsewhere herein, may enable certain portions of structure 100 to be formed and processed differently from each other to affect the shape of conductive contacts to bipolar transistor 110.

A set of base contacts 142 through ILD layer 140 may provide the vertical electrical coupling between extrinsic base 116 and overlying metal wires and/or vias. Base contacts 142, notably, do not extend to intrinsic base 112. Intrinsic base 112 thus are coupled to base contacts 142 only through extrinsic base 116. Some portions of extrinsic base 116 may be converted into a silicide layer 148 to improve conductivity between each base contact 142 and any portions of extrinsic base 116 thereunder, e.g., by providing a conductive metal such as cobalt (Co), titanium (Ti), nickel (Ni), platinum (Pt), or similar material on the upper surface(s) of a targeted material. The conductive material(s) may be annealed while in contact with the underlying semiconductor to produce silicide layer 148 for electrically coupling semiconductor materials to any contacts formed thereon. Excess conductive material can then be removed using any now known or later developed solution, e.g., etching.

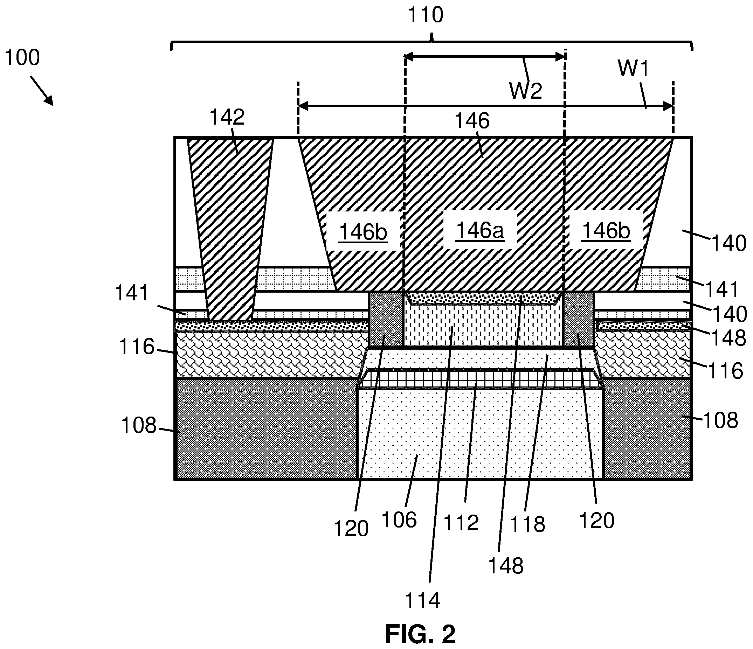

Structure 100 also includes an emitter contact 146 to emitter 114 and a collector contact 144 to collector 106 through subcollector 102. As will be discussed in further detail relative to FIG. 2, emitter contact 146 can be significantly larger (i.e., horizontally wider) than emitter 114 and also may be wider than other contacts 142, 144 of structure 100 Each contact 146, 144 also may be coupled to emitter 114 or subcollector 102, respectively, through silicide layers 148 formed therein. Each contact 142, 144, 146 also may extend through ILD layer 140, thus electrically connecting active semiconductor material within subcollector 102 or emitter 114 to overlying metal wires, vias, etc., above structure 100. Contact(s) 142, 144, 146 optionally may be formed as part of a single operation, e.g., by removing portions of ILD layer 140 to form openings, forming silicide layers 148 on semiconductor materials exposed within the openings, and filling the openings with metal to define each contact 142, 144, 146. One or more of contacts 142, 144, 146 may include refractory metal liners (not separately shown) on their sidewalls to impede or prevent electromigration degradation, shorting to other components, etc.

Some portions of subcollector 102, emitter 114, and extrinsic base 116 may be converted into a silicide layer 148 to improve conductivity between each contact 142, 144, 146 and any active material thereunder, e.g., by providing a conductive metal such as cobalt (Co), titanium (Ti), nickel (Ni), platinum (Pt), or similar material on the upper surface(s) of a targeted material. The conductive material(s) may be annealed while in contact with the underlying semiconductor to produce silicide layer 148 for electrically coupling semiconductor materials to any contact(s) formed thereon. Excess conductive material can then be removed using any now known or later developed solution, e.g., etching.

Referring now to FIG. 2, which provides an expanded cross-sectional view of base contact 142, emitter contact 146, and corresponding portions of bipolar transistor 110, additional features of structure 100 are discussed. Emitter contact 146 generally may have a first horizontal width W1 within ILD layer 140 and/or within barrier film 141 where applicable. First horizontal width W1, optionally, may be non-uniform. For instance, where emitter 146 includes tapered or otherwise non-linear sidewalls, the size of first horizontal width W1 may be location dependent. In the example of FIG. 2, emitter contact 146 is widest at its uppermost vertical position distal to emitter 114 and narrowest at its lowermost vertical position proximal to emitter 114. In such cases, first horizontal width W1 may be at a particular location or may be derived from differing widths at individual locations (e.g., it may be an average horizontal width, maximum horizontal width, or minimum horizontal width). However calculated, first horizontal width W1 is greater than a second horizontal width W2 of emitter 114 thereunder between spacers 120. In an example configuration, the smallest value of horizontal width W1 in emitter contact 146 nonetheless may be greater than any value of second horizontal width W2 along the vertical span of emitter 114. In some implementations, the difference between first horizontal width W1 and second horizontal width W2 may be sufficiently large such that first horizontal width W1 is at last twice as large as second horizontal width W2 (e.g., it may be three times as large or even larger).

The difference in horizontal widths W1, W2 of emitter contact 146 and emitter 114 may produce certain structural characteristics. For example, emitter contact 146 may be subdivided into a first portion 146a and a second portion 146b due to the size of its horizontal width(s) W1. First portion 146a may include any or all portions of emitter contact 146 located directly vertically above emitter 114 (regardless of whether silicide layer 148 is also located therebetween). Second portion(s) 146b of emitter contact 146 may include any or all portions located vertically over components other than and on opposing sides of emitter 114, e.g., dielectric materials such as spacer(s) 120, ILD layer(s) 140, etc. According to the example of FIG. 2, second portions 146b of emitter contact 146 physically interfaces with multiple dielectric materials by being on spacer(s) 120 and on adjacent portions of ILD(s) 140. Thus, first portion(s) 146a may have lower surfaces defining electrically conductive interfaces within bipolar transistor 110, whereas second portion(s) 146b may have lower surfaces defining a metal-to-dielectric material interface within structure 100. At least part of second portion(s) 146b of emitter contact 146, in addition, may be vertically above silicide layer(s) 148 that are located on extrinsic base 116. Thus, portions of emitter contact 146, in contrast with conventional bipolar transistor structures, vertically overlie active material(s) included within extrinsic base(s) 116. These and other physical characteristics discussed herein thus cause contacts 142, 146 to be horizontally closer together than the respective terminals 116, 114 of bipolar transistor 110 thereunder.

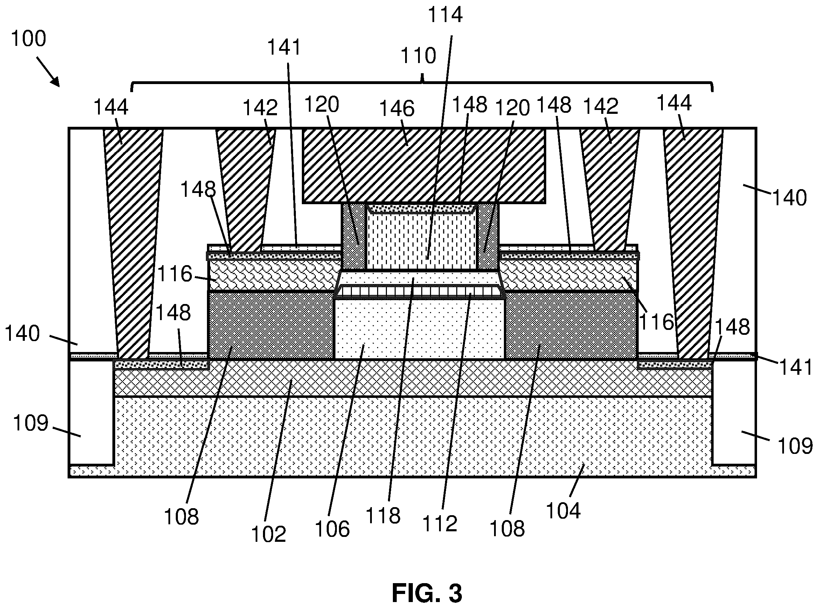

FIG. 3 depicts a further implementation of structure 100 in which emitter contact 146 is processed separately from base contact 142 and collector contact 144. In this case, instead of forming barrier film 141 to define the lower extent of emitter contact 146, embodiments of the disclosure may include forming ILD layer 140, forming openings in ILD layer 140 to form base contacts 142 and collector contact 144, and then separately performing a non-selective vertical etch (e.g., reactive ion etching (RIE)) with a mask (not shown) over contacts 142, 144 and non-targeted areas of ILD 140 to define the width of the eventual emitter contact 146. The etching may be controlled such that it terminates before removing significant portions of emitter 114, spacer(s) 120, and/or silicide layer 148. Emitter contact 146 then can be formed by depositing conductive metal(s) within the removed areas, and thus emitter contact 146 can be over emitter 114 and adjacent portions(s) of spacer(s) 120 and ILD layer 140 similarly to other implementations.

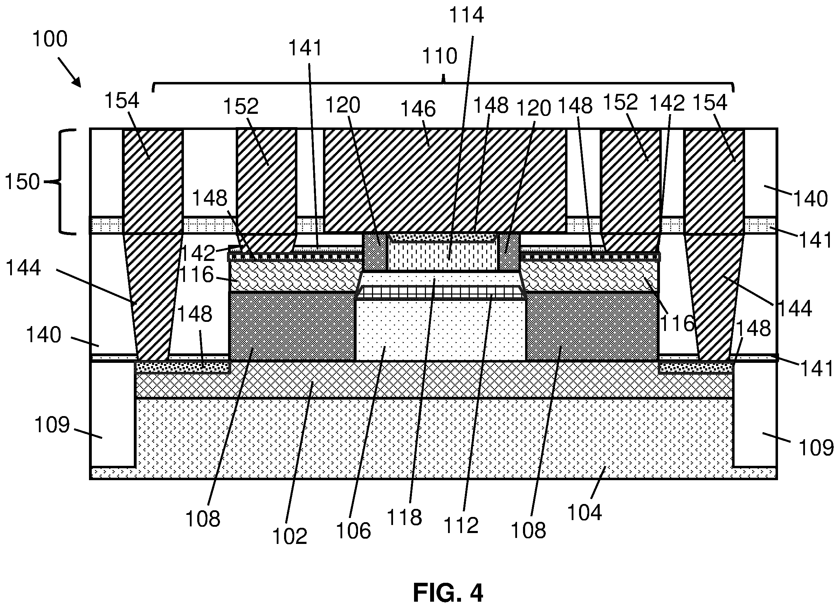

Referring to FIG. 4, additional implementations of structure 100 may include emitter contact 146 in a metal wiring layer 150 instead of underlying portions of ILD layer 140. In some implementations, barrier film 141 may define the lower boundary of a metal wiring layer 150 to provide vertical and horizontal couplings to other device components. Metal wiring layer 150 may include another ILD layer 140 therein. Metal wiring layer 150 further may include base conductors 152 to base contacts 142 and collector conductors 154 to collector contacts 144. Conductors 152, 154 may have the same or similar composition as contacts 142, 144, thereunder and thus may include conductive metals (copper, aluminum, etc.). Conductors 152, 154 may be differentiated from contacts 142, 144 by being within metal wiring layer 150 instead of ILD layer(s) 140 located below metal wiring layer 150 and barrier film 141. Metal wiring layer 150 also may include emitter contact 146 therein. In this case, emitter contact 146 may be formed together within conductors 152, 154 instead of being formed together with other contacts 142, 144. Emitter contact 146 thus may be located at least partially above contacts 142, 144 but still exhibits a larger horizontal width than emitter 114. In the example of FIG. 4, and in any other implementation of structure 100 discussed herein, emitter contact 146 optionally may have a horizontal width that is larger than a combined horizontal width of base contacts 142 and collector contacts 144 to bipolar transistor 110. Emitter contact 146, in this case, also may have a horizontal width that is larger than a combined horizontal width of base conductors 152 and collector conductors 154 to bipolar transistor 110.

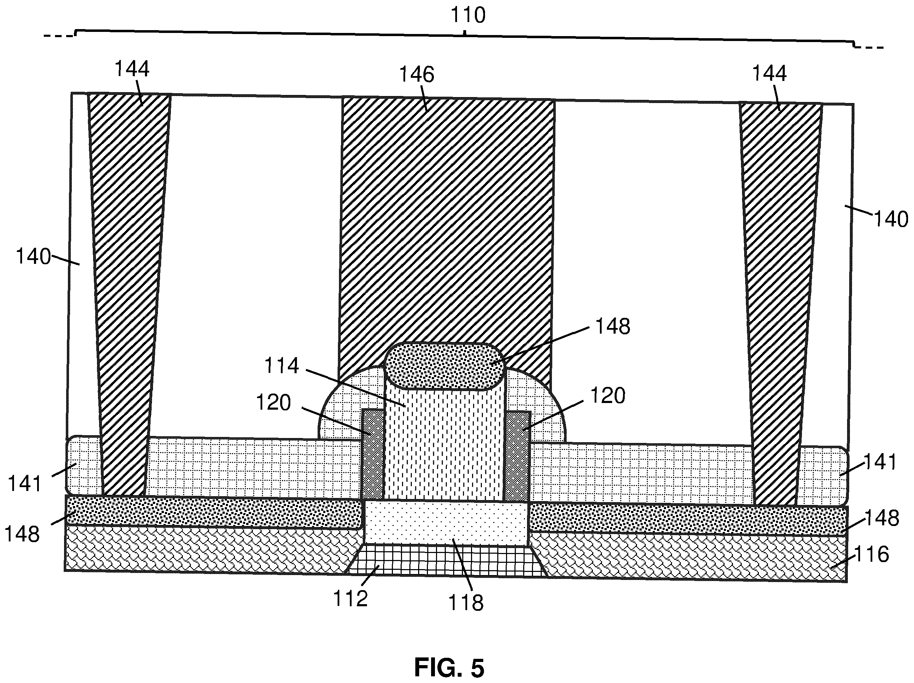

Turning to FIG. 5, in which an expanded partial view of structure 100 is shown, further configurations may enable forming of base contacts 144 and emitter contact 146 within one ILD layer 140 while maintaining the larger horizontal width of emitter contact 146. In this case, after extrinsic bases 116, emitter 114, and spacers 120 are formed, barrier film 141 may be formed conformally on these components. Portions of barrier film 141 over emitter 114 may be removed by vertical etching and silicide layer 148 can be formed on emitter 114 in its place. ILD layer 140 then can be formed over silicide layer and barrier film 141. Here, base contacts 144 can be formed by non-selective directional etching of ILD layer 140 and barrier film 141 and forming conductive material(s) within the etched portions. Emitter contact 146, however, can be formed by selectively etching a wider area of ILD layer 140 over silicide layer 148 and using barrier film 141 and silicide layer 148 as "etch stop layers" to prevent underlying portions of emitter 114 from being removed. Emitter contact 146 then can be formed in place of the removed materials such that emitter contact 146 has a larger horizontal width than emitter 114 thereunder.

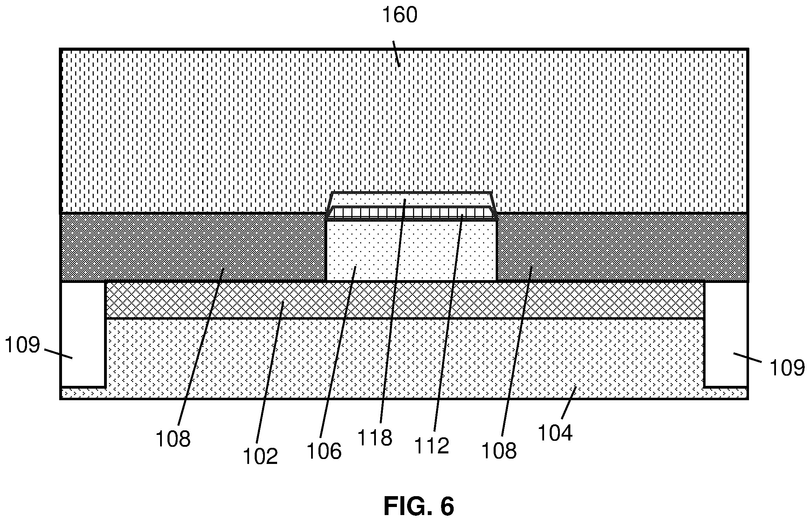

Turning to FIG. 6, methods of forming structure(s) 100 (FIGS. 1-5) according to any configuration discussed herein are provided. Initial phases of processing may include forming subcollector 102 on substrate 104 (e.g., by targeted doping of semiconductor material to desired concentrations), forming insulator(s) 109 and/or other isolating materials adjacent subcollector 102 and substrate 104, etc. Further processing may include forming isolation layers 108 on subcollector 102 and insulator 109 adjacent subcollector 102 therebetween e.g., by forming layers of insulating material on substrate 104 and subcollector 102 by deposition or other currently known or later developed techniques to provide insulator materials. To form collector 106, an opening (not shown) can be formed within the deposited isolation layer(s) 108 and substrate 104 can be formed within the opening, e.g., by epitaxial growth and doping of semiconductor material on subcollector 102 within the opening. **In** the case of forming by epitaxial growth, collector 106 may have sidewall shapes dependent on the shape of isolation layer(s) 108, the manner of growth implemented and/or the crystallographic orientation of subcollector 102 thereunder. Collector 106 may not completely horizontally fill the opening within isolation layer(s) 108 once formed, e.g., by controlling the amount of deposition time and/or etching back collector 106 material once it is formed.

Further processing may include, e.g., forming intrinsic base 112 as a monocrystalline semiconductor material on collector 106. Intrinsic base 112 may be undoped or have an opposite doping type from collector 106, and in addition, may have a lower concentration of dopants therein. Collector 106 and/or intrinsic base 112 may be doped through implantation and/or other currently known or later developed doping techniques. The forming of intrinsic base 112 may begin only after collector 106 is at or near the height of isolation layer(s) 108 above subcollector 102. Semiconductor film 118 then may be created by non-selective forming of, e.g., a layer of semiconductor material, doped during growth or after growth *in situ* to have the same conductivity as intrinsic base 112, with a different composition and/or crystallographic orientation on intrinsic base 112. Semiconductor film 118 may be formed such that its upper surface is substantially coplanar with, or optionally located above, adjacent upper surfaces of isolation layers 108. Semiconductor film 118 may be doped by any conceivable process, e.g., by thermal anneal after semiconductor film 118 is formed. In subsequent processing, semiconductor film 118 may function as a part of intrinsic base 112 but also may provide an etch stop layer to control the location and size of emitter 114 (FIGS. 1-5), as described in various embodiments herein.

An emitter layer 160, e.g., doped polycrystalline silicon ("polysilicon") may be on isolation layers 108 and semiconductor film 118, e.g., by non-selective deposition and doping of semiconductor material(s) thereon. Emitter layer 160 may be recessed and/or partially removed in subsequent processing as discussed herein to enable forming of extrinsic base(s) 116 (FIGS. 1-5) and adjacent spacers 120 to maintain electrical and structural separation between the eventual emitter and base terminals of bipolar transistor 110 (FIGS. 1-5).

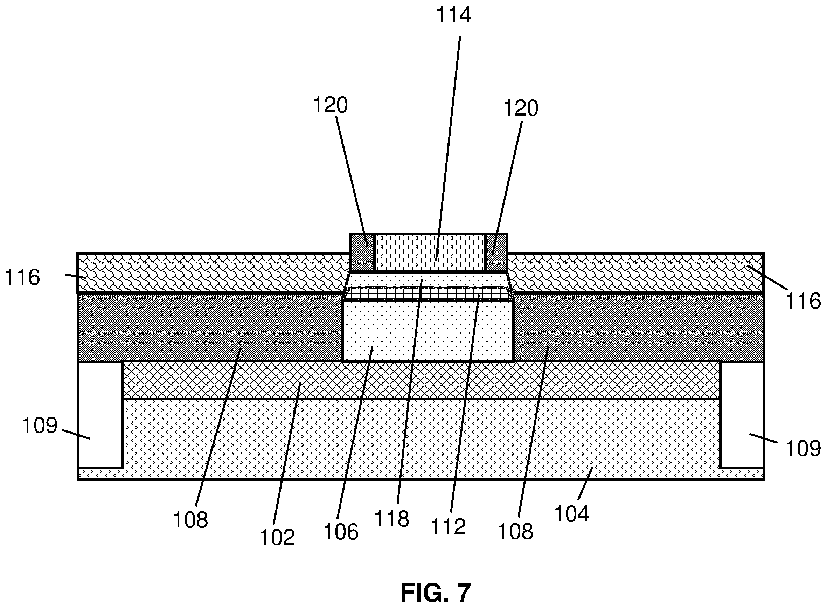

FIG. 7 depicts the forming of remaining active terminals for bipolar transistor 110 (FIGS. 1-5), e.g., by recessing emitter layer 160 (FIG. 6) to a desired height, forming a mask (not shown) on emitter layer 160 above intrinsic base 112, removing portions of emitter layer 160 below the mask, and doping the remaining polysilicon material to define emitter 114 with a desired size and doping concentration. Emitter 114 may be doped to have the same doping type as subcollector 102 and collector 106, e.g., P-type or N-type doping based on whether the eventual bipolar transistor 110 will have a PNP or NPN configuration. Spacers 120 can then be formed alongside emitter 114, e.g., by depositing a layer of insulative material to a desired thickness and then vertically etching the insulative material, such that the vertical etching does not remove any portions of dielectric material covering the sidewalls of emitter 114. Extrinsic base 116 similarly can be formed by forming a mask on emitter 114 and/or spacer(s) 120, depositing, etching back, and/or doping semiconductor material (e.g., silicon germanium (SiGe) or similar substances) to have a desired configuration. Extrinsic base 116, once formed, may have an upper surface above semiconductor film 118 but less than the height of spacer(s) 120. Spacer(s) 120 thus horizontally separate extrinsic base 116 from emitter 114.

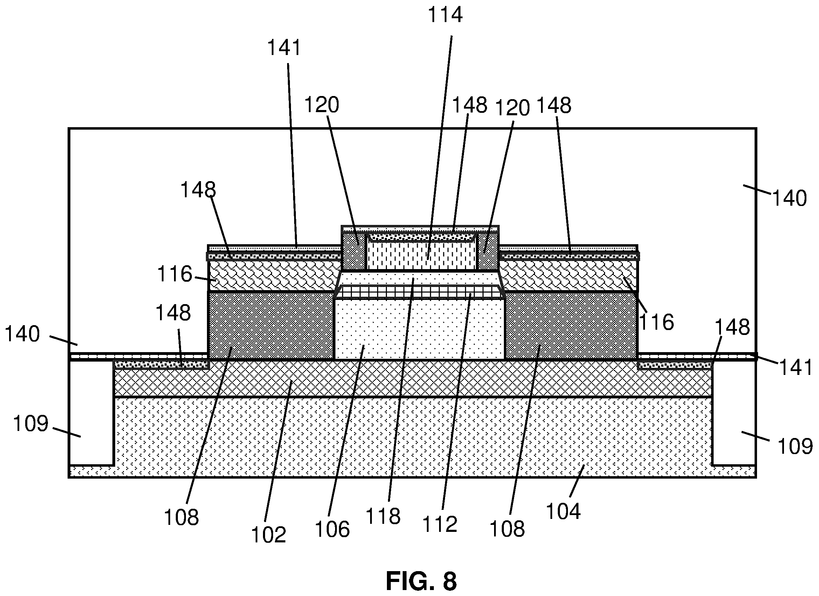

Turning to FIG. 8, any horizontally outer portions of isolation layer(s) 108 and extrinsic base(s) 116 then can be removed by targeted etch. Silicide layer(s) 148 then can be formed, optionally simultaneously, within exposed upper surfaces of subcollector 102, emitter 114, and/or extrinsic base 116 by depositing metal thereon, annealing the metal to diffuse metal ions into the underlying semiconductor material, and removing excess metal. Optionally, a set of barrier films 141 may be formed by deposition on exposed upper surfaces of material (e.g., on any silicide layer(s) 148, on insulators 109 and spacers 120, etc.), to protect the material(s) thereunder from being affected in further processing. ILD layer(s) 140 then may be formed over the partially formed structure via deposition and/or planarization.

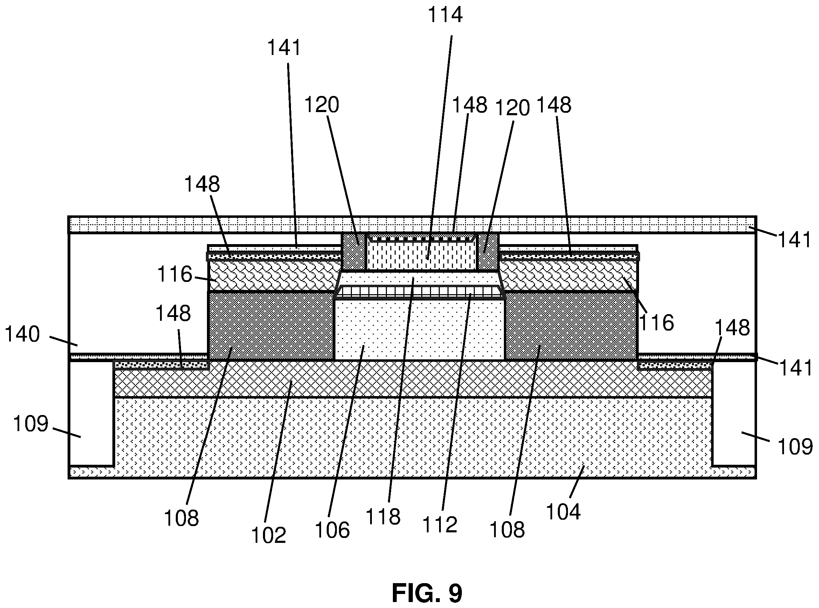

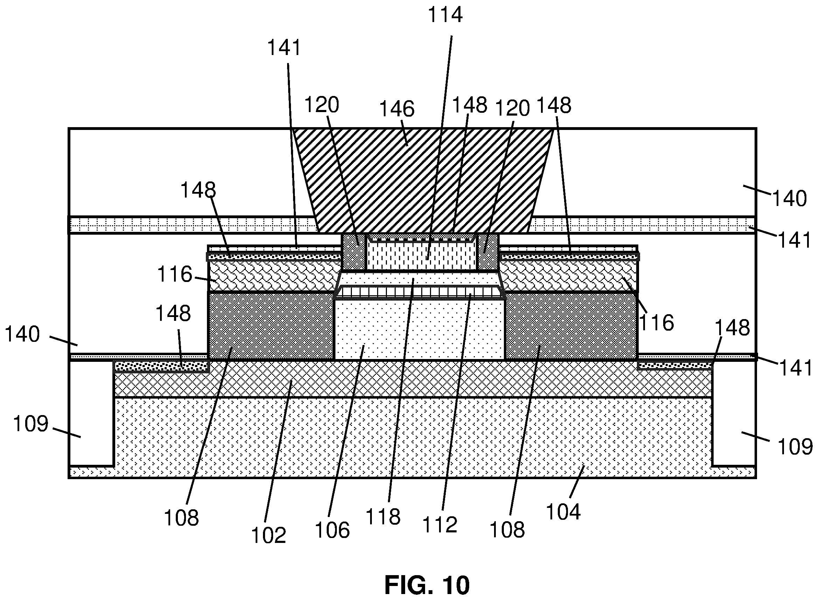

FIGS. 9 and 10 depict remaining processes to form structure 100 (FIGS. 1-5) in some embodiments. For instance, FIG. 9 depicts partial recessing of ILD layer 140 to approximately the height of emitter 114, and thereafter forming another barrier layer 141 thereon. Barrier layer 141 may function as an etch stop layer for independent processing of different contacts, or simply may be to vertically separate the previously formed active materials from overlying metal wiring layers. FIG. 10 depicts forming another ILD layer 140 on barrier layer 141, removing a targeted portion of ILD layer 140 to the depth of emitter 114 using barrier layer 141 as an etch stop material, and replacing the removed ILD layer 140 material with emitter contact 146 of a predetermined desired horizontal width. Thus, as shown in FIG. 10, emitter contact 146 is formed without any other contacts (e.g., base contact 142 and collector contact 144 discussed herein) also being formed in respective positions. By first forming emitter contact 146, emitter contact 146 may have a greater horizontal width than emitter 114 thereunder. Subsequent processing then may include, e.g., covering emitter contact 146 and other portions of ILD layer 140 with a mask and forming contact(s) 142, 144 (FIGS. 1-5) by removing targeted areas of ILD layer 140 and barrier layer 141, and forming conductive materials in the empty space to provide contact(s) 142, 144 where desired.

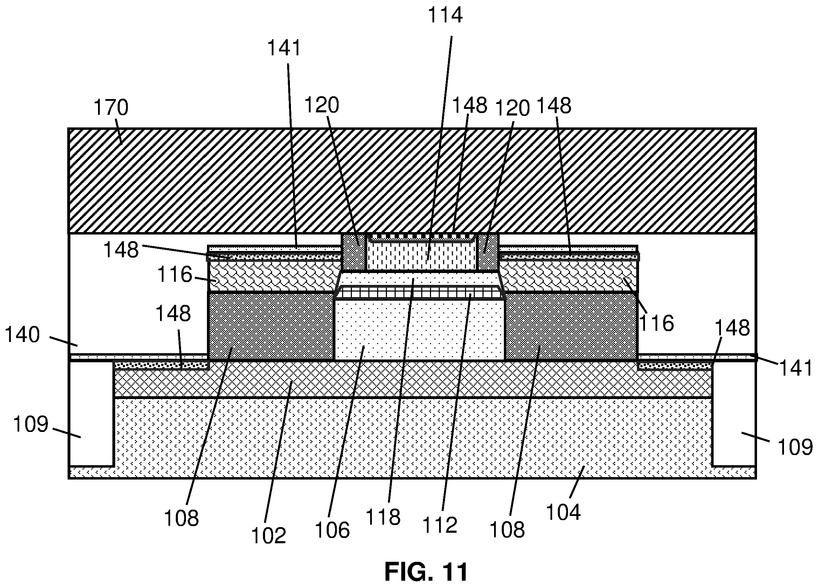

Referring now to FIGS. 8 and 11 together, alternative processing may include partially recessing ILD layer 140 and removing any barrier layer 141 material on emitter 114 such that silicide layer 148 for emitter 114 is exposed. A conductive layer 170 (e.g., copper, aluminum, other conductors discussed herein) then can be formed by deposition of such material(s) over emitter 114 and the remaining areas of ILD layer 140. Portions of conductive layer 170 over emitter 114 can then be covered with a temporary mask having the desired width of the eventual emitter contact 146 (FIGS. 1-5). Portions of conductive layer 170 not covered by the mask can then be removed and replaced again with ILD layer 140 material by depositing insulative material(s) in its place. The resulting emitter contact 146 thus may be positioned substantially as shown, e.g., in FIG. 3, with a greater horizontal width than emitter 114. Base contact 142 and collector contact 144 then can be formed as discussed elsewhere herein relative to FIG. 10.

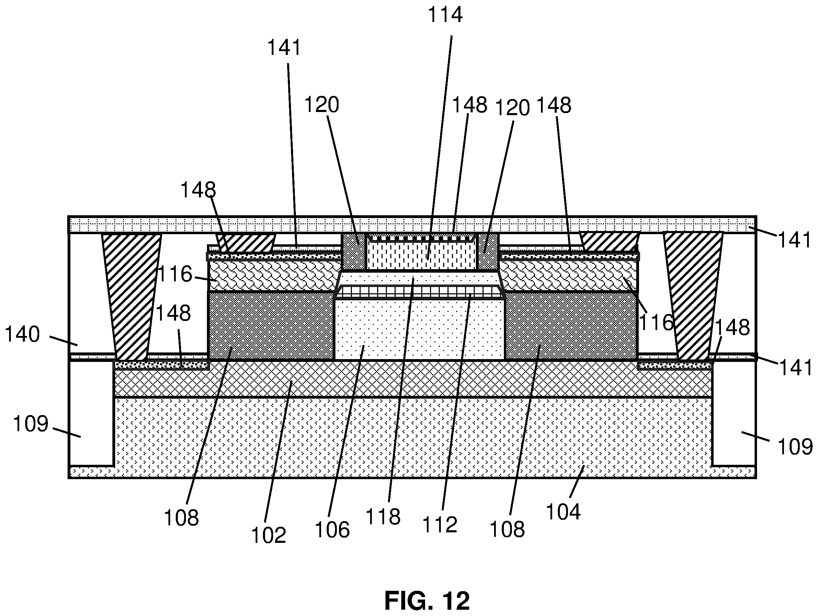

Referring to FIGS. 9 and 12, further implementations may include forming base contacts 142 and collector contacts 144 before emitter contact 146. Here, after barrier layer 141 is formed, further processing may include forming openings in ILD layer 140 and barrier layer 141, forming the openings with conductive material to form contacts 142, 144, and then re-forming barrier layer 141 over contact(s) 142, 144 to enable forming of other materials thereover. According to an example shown in FIG. 4, subsequent processing may include forming wiring layer 150 and forming conductors 152, 154 in addition to emitter contact 146 within wiring layer 150.

Embodiments of the disclosure provide various technical and commercial advantages, examples of which are discussed herein. Embodiments of the disclosure assist fabrication tools and facilities in vertically landing emitter contacts 146 on emitters 114 of variable shapes and decreasing size. The structures and methods discussed herein, in addition, reduce base to emitter resistance and base to emitter capacitance by preventing spatial overlap between semiconductor materials (particularly polysilicon) of emitter 114 and extrinsic base(s) 116. The wider size of emitter contacts 146 also, in addition, improve thermal management by reducing internal electrical resistance along the pathway between emitter 114 and metal wiring levels thereover.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the disclosure provides a structure with an emitter contact wider than an emitter terminal, and related methods. A structure of the disclosure includes an emitter contact within an inter-level dielectric (ILD) layer and on an emitter terminal of a bipolar transistor, wherein a horizontal width of the emitter contact is greater than a horizontal width of the emitter terminal thereunder.
The following illustrative embodiments are explicitly disclosed.
Embodiment 1: A structure comprising:
   an emitter contact within an inter-level dielectric (ILD) layer and on an emitter terminal of a bipolar transistor, wherein a horizontal width of the emitter contact is greater than a horizontal width of the emitter terminal thereunder.
Embodiment 2: The structure of embodiment 1, wherein the emitter contact includes a first portion on the emitter terminal and a second portion on a dielectric layer adjacent the emitter terminal, and adjacent the first portion.
Embodiment 3: The structure of embodiment 2, wherein the second portion is above an extrinsic base of the bipolar transistor, and wherein the extrinsic base is horizontally distal to the emitter terminal.
Embodiment 4: The structure of embodiment 3, wherein the second portion is vertically above a silicide layer on the extrinsic base.
Embodiment 5: The structure of one of embodiments 2 to 4, wherein the second portion of the emitter contact includes a lower surface interfacing with an upper surface of a plurality of dielectric materials.
Embodiment 6: The structure of one of embodiments 1 to 5, wherein the horizontal width of the emitter contact is at least approximately twice the horizontal width of the emitter terminal.
Embodiment 7: The structure of one of embodiments 1 to 6, further comprising:
   a collector contact within the ILD layer horizontally distal to the emitter contact; and
   a base contact within the ILD layer horizontally between the emitter contact and the collector contact, wherein the horizontal width of the emitter contact is larger than a combined horizontal width of the collector contact and the base contact.
   In some illustrative embodiments of the structure of one of embodiments 1 to 7 may represent a bipolar junction transistor contact and terminal structure.
Embodiment 8: The structure of one of embodiments 1 to 7, wherein the bipolar transistor comprises:
   a collector terminal including an epitaxial semiconductor material on a subcollector;
   an isolation layer on the subcollector and adjacent the collector terminal;
   a base terminal including:
      an intrinsic base on the collector terminal, wherein a semiconductor film is on the intrinsic base; and
      an extrinsic base adjacent the semiconductor film and on an upper surface of the isolation layer and in contact with the intrinsic base;
   the emitter terminal formed on the semiconductor film; and
   the emitter contact formed within the inter-level dielectric (ILD) layer and on the emitter terminal.
   For example, the structure of embodiment 8 may be a bipolar junction transistor structure, comprising:
   a collector terminal including an epitaxial semiconductor material on a subcollector;
   an isolation layer on the subcollector and adjacent the collector terminal;
   a base terminal including:
      an intrinsic base on the collector terminal, wherein a semiconductor film is on the intrinsic base; and
      an extrinsic base adjacent the semiconductor film and on an upper surface of the isolation layer and in contact with the intrinsic base;
   the emitter terminal formed on the semiconductor film; and
   the structure bipolar junction transistor contact and terminal structure of one of embodiments 1 to 7.
Embodiment 9: A structure comprising:
   a collector terminal including an epitaxial semiconductor material on a subcollector;
   an isolation layer on the subcollector and adjacent the collector terminal;
   a base terminal including:
      an intrinsic base on the collector terminal, wherein a semiconductor film is on the intrinsic base; and
      an extrinsic base adjacent the semiconductor film and on an upper surface of the isolation layer and in contact with the intrinsic base;
   an emitter terminal on the semiconductor film; and
   an emitter contact within an inter-level dielectric (ILD) layer and on the emitter terminal, wherein a horizontal width of the emitter contact is greater than a horizontal width of the emitter terminal thereunder.
   In some illustrative embodiments of embodiment 8 or 9, the structure may represent a bipolar junction transistor (BJT) structure.
Embodiment 10: The structure of embodiment 8 or 9, wherein the emitter contact includes a first portion on the emitter terminal and a second portion on a dielectric layer adjacent the emitter terminal, and adjacent the first portion.
Embodiment 11: The structure of embodiment 9, wherein the second portion is above the extrinsic base, and wherein the extrinsic base is horizontally distal to the emitter terminal.
Embodiment 12: The structure of embodiment 10, further comprising a silicide layer on the extrinsic base, wherein the second portion is vertically the silicide layer.
Embodiment 13: The structure of embodiment 8, wherein the horizontal width of the emitter contact is at least approximately twice the horizontal width of the emitter terminal.
Embodiment 14: The structure of embodiment 8, further comprising:
   a collector contact on the subcollector and within the ILD layer horizontally distal to the emitter contact; and
   a base contact on the extrinsic base within the ILD layer horizontally between the emitter contact and the collector contact, wherein the horizontal width of the emitter contact is larger than a combined horizontal width of the collector contact and the base contact.
Embodiment 15: A method comprising:
   forming an emitter contact within an inter-level dielectric (ILD) layer and on an emitter terminal of a bipolar transistor, wherein a horizontal width of the emitter contact is greater than a horizontal width of the emitter terminal thereunder.
Embodiment 16: The method of embodiment 15, further comprising forming a first portion of the emitter contact on the emitter terminal and forming a second portion on a dielectric layer adjacent the emitter terminal, and adjacent the first portion.
Embodiment 17: The method of embodiment 16, further comprising forming the second portion above an extrinsic base of the bipolar transistor, wherein the extrinsic base is horizontally distal to the emitter terminal.
Embodiment 18: The method of embodiment 17, wherein the second portion is vertically above a silicide layer on the extrinsic base.
Embodiment 19: The method of one of embodiments 16 to 18, wherein the second portion of the emitter contact includes a lower surface interfacing with an upper surface of a plurality of dielectric materials.
Embodiment 20: The method of one of embodiments 15 to 19, wherein the horizontal width of the emitter contact is at least approximately twice the horizontal width of the emitter terminal.
Embodiment 21: The method of one of embodiments 15 to 20, further comprising:
   forming a collector contact within the ILD layer horizontally distal to the emitter contact; and
   forming a base contact within the ILD layer horizontally between the emitter contact and the collector contact, wherein the horizontal width of the emitter contact is larger than a combined horizontal width of the collector contact and the base contact.
Embodiment 22: The method of one of embodiments 15 to 21, wherein the structure of one of embodiments 1 to 14 is formed.

## Claims

1. A structure comprising:
an emitter contact within an inter-level dielectric (ILD) layer and on an emitter terminal of a bipolar transistor, wherein a horizontal width of the emitter contact is greater than a horizontal width of the emitter terminal thereunder.

2. The structure of claim 1, wherein the emitter contact includes a first portion on the emitter terminal and a second portion on a dielectric layer adjacent the emitter terminal, and adjacent the first portion.

3. The structure of claim 2, wherein the second portion is above an extrinsic base of the bipolar transistor, and wherein the extrinsic base is horizontally distal to the emitter terminal.

4. The structure of claim 3, wherein the second portion is vertically above a silicide layer on the extrinsic base.

5. The structure of one of claims 2 to 4, wherein the second portion of the emitter contact includes a lower surface interfacing with an upper surface of a plurality of dielectric materials.

6. The structure of one of claims 1 to 5, wherein the horizontal width of the emitter contact is at least approximately twice the horizontal width of the emitter terminal.

7. The structure of one of claims 1 to 6, further comprising:
a collector contact within the ILD layer horizontally distal to the emitter contact; and
a base contact within the ILD layer horizontally between the emitter contact and the collector contact, wherein the horizontal width of the emitter contact is larger than a combined horizontal width of the collector contact and the base contact.

8. The structure of one of claims 1 to 7, wherein the bipolar transistor comprises:
a collector terminal including an epitaxial semiconductor material on a subcollector;
an isolation layer on the subcollector and adjacent the collector terminal;
a base terminal including:
an intrinsic base on the collector terminal, wherein a semiconductor film is on the intrinsic base; and
an extrinsic base adjacent the semiconductor film and on an upper surface of the isolation layer and in contact with the intrinsic base;
the emitter terminal formed on the semiconductor film; and
the emitter contact formed within the inter-level dielectric (ILD) layer and on the emitter terminal.

9. The structure of claim 8 in combination with claim 2 or 3, further comprising a silicide layer on the extrinsic base, wherein the second portion is vertically the silicide layer.

10. The structure of claim 8 or 9, further comprising:
a collector contact on the subcollector and within the ILD layer horizontally distal to the emitter contact; and
a base contact on the extrinsic base within the ILD layer horizontally between the emitter contact and the collector contact, wherein the horizontal width of the emitter contact is larger than a combined horizontal width of the collector contact and the base contact.

11. A method comprising:
forming an emitter contact within an inter-level dielectric (ILD) layer and on an emitter terminal of a bipolar transistor, wherein a horizontal width of the emitter contact is greater than a horizontal width of the emitter terminal thereunder.

12. The method of claim 11, further comprising forming a first portion of the emitter contact on the emitter terminal and forming a second portion on a dielectric layer adjacent the emitter terminal, and adjacent the first portion.

13. The method of claim 12, wherein the second portion of the emitter contact includes a lower surface interfacing with an upper surface of a plurality of dielectric materials; and/or wherein the method further comprises forming the second portion above an extrinsic base of the bipolar transistor, wherein the extrinsic base is horizontally distal to the emitter terminal, the second portion preferably being vertically above a silicide layer on the extrinsic base.

14. The method of one of claims 11 to 13, wherein the horizontal width of the emitter contact is at least approximately twice the horizontal width of the emitter terminal.

15. The method of one of claims 11 to 14, further comprising:
forming a collector contact within the ILD layer horizontally distal to the emitter contact; and
forming a base contact within the ILD layer horizontally between the emitter contact and the collector contact, wherein the horizontal width of the emitter contact is larger than a combined horizontal width of the collector contact and the base contact.
